(19)

Europäisches
Patentamt
European
Patent Office
Office européen
des brevets

(11)     **EP 2 708 617 A1**

(12)                **EUROPEAN PATENT APPLICATION**
                published in accordance with Art. 153(4) EPC

(43) Date of publication:
    **19.03.2014   Bulletin 2014/12**

(51) Int Cl.:
    **C23C 16/27** (2006.01)     **C10M 103/02** (2006.01)
    **C10N 30/06** (2006.01)     **C10N 40/02** (2006.01)

(21) Application number: **12781837.5**

(22) Date of filing: **10.05.2012**

(86) International application number:
    **PCT/JP2012/062061**

(87) International publication number:
    **WO 2012/153819 (15.11.2012 Gazette 2012/46)**

(84) Designated Contracting States:
    **AL AT BE BG CH CY CZ DE DK EE ES FI FR GB
    GR HR HU IE IS IT LI LT LU LV MC MK MT NL NO
    PL PT RO RS SE SI SK SM TR**

(30) Priority:  **10.05.2011   JP 2011105166**

(71) Applicant: **National Institute of Advanced
    Industrial Science
    and Technology
    Tokyo 100-8921 (JP)**

(72) Inventors:
    • **TSUGAWA, Kazuo**
      **Tsukuba-shi**
      **Ibaraki 305-8565 (JP)**
    • **KAWAKI, Shunsuke**
      **Tsukuba-shi**
      **Ibaraki 305-8565 (JP)**

    • **ISHIHARA, Masatou**
      **Tsukuba-shi**
      **Ibaraki 305-8565 (JP)**
    • **KOGA, Yoshinori**
      **Tsukuba-shi**
      **Ibaraki 305-8565 (JP)**
    • **HASEGAWA, Masataka**
      **Tsukuba-shi**
      **Ibaraki 305-8565 (JP)**
    • **KIM, Jaeho**
      **Tsukuba-shi**
      **Ibaraki 305-8565 (JP)**

(74) Representative: **Peterreins, Frank
    Fish & Richardson P.C.
    Highlight Business Towers
    Mies-van-der-Rohe-Strasse 8
    80807 München (DE)**

(54)     **CARBON FILM LAMINATE, METHOD OF MANUFACTURING SAID LAMINATE, AND
         LUBRICANT USING SAID LAMINATE**

(57)     An object of the invention is to provide a carbon film laminate having a sliding surface with low friction, low abrasion, and low counterpart aggressiveness using high adhesiveness to a base material, hardness, surface flatness, low counterpart aggressiveness, transparency, and high thermal conductivity which are provided to the carbon film without using liquid and semiliquid lubricants such as lubricating oil. Provided is a carbon film laminate including a base material, a carbon film adhesion reinforcing layer which is provided on the base material and which is formed from silicon oxide (SiOx, x= 1 to 2) containing fluorine atoms (F) in a concentration of $1 \times 10^{19}$ atoms/cm$^3$ or more, and a carbon film that is formed on the carbon film adhesion reinforcing layer. The carbon film contains fluorine atoms in the film in a concentration of $1 \times 10^{19}$ to $1 \times 10^{21}$ atoms/cm$^3$, and has an approximate spectrum curve obtained by superimposing, on a peak fitting curve A at a Bragg angle ($2\theta \pm 0.5°$) of 43.9° in an X-ray diffraction spectrum by CuK$\alpha_1$ rays, a peak fitting curve B at 41.7° and a baseline.

FIG.  1

EP 2 708 617 A1

**Description**

Technical Field

The present invention relates to a carbon film laminate, a method of manufacturing the carbon film laminate, and a lubricant using the carbon film laminate.

Background Art

As examplified by engine oil of a vehicle, a liquid lubricant, particularly, oils in which have high viscosity and have a strong film , are generally used for the lubrication of sliding components.

However, such oil-based liquid lubricants, generally, cannot be used in food processing machines, components for business machine, aerospace machines, semiconductor-related manufacturing devices, special environments such as a high temperature environment, a vacuum environment, a clean environment, and an ultra-clean environment, ultra-small machines, and the like. Therefore, a lubricant capable of being used in these cases, or countermeasures for providing self-lubricating properties to a sliding and frictional unit surface is in demand. In addition, detriment to the environment due to disposal of deteriorated oil becomes problematic when using oil as a liquid for lubrication.

As countermeasures against these cases, a method of using a solid lubricant, and a method of providing the self-lubricating property by surface modification of sliding units have been put to practical use.

As the solid lubricant, molybdenum disulfide ($MoS_2$), graphite, polytetrafluoroethylene (PTFE), and the like have been frequently used. As other examples, graphite fluoride (($CF)_n$), boron nitride (BN), tungsten disulfide ($WS_2$), and the like may be exemplified. Among these, the molybdenum disulfide and the tungsten disulfide which are frequently used are environmentally detrimental sulfur compounds, and there is a problem in that a load is applied to the environment during disposal and thus a disposal treatment is necessary. In addition, the sulfur compounds and boron nitride contain molybdenum (Mo), boron (B), or tungsten (W) that is a rare metal. A producing district of the rare metal is extremely localized, a supply amount thereof is limited, and it is difficult to obtain the rare metal due to a recent increase in demand. In addition, a country that produces the rare metal is extremely rare, and thus it is expected that it is more difficult to obtain the rare metal in the future due to policies, economic situations, unstable political situations, and the like.

As an application method of the solid lubricant, mainly, there are two methods including a method of using the solid lubricant by dispersing it in lubricating oil, grease, or paste, and a method of using the solid lubricant as a dry lubricating film (dry film) by compositing the solid lubricant with a resin material or the like. Particularly, in an application in which liquid lubrication may not be used, the dry film is mainly used. However, the solid lubricant itself or the film material is a soft material and is damaged due to friction. Therefore, a long operational lifespan is a major issue. In addition, generally, a spraying method has been spreading widely for application of the dry film, but application efficiency is as low as approximately 15%, and a large environmental load is problematic. In addition, in the dry film, since the solid lubricant itself is colored and is opaque, or in a case of containing a binder, the solid lubricant is colored and is opaque due to the binder, there is a problem in that a base material onto which the dry film is applied is colored.

On the other hand, an ion injection method and the like have been used for surface modification of sliding members in the related art. Recently, in place of the above-described methods, a ceramic coating and a diamond-like carbon (DLC) film have been put to practical use. Particularly, the DLC film has excellent mechanical characteristics such as a low frictional property, abrasion resistance, high hardness, chemical stability, adhesion resistance, and smoothness, and thus the DLC film has been applied to electric and electronic products such as a bearing, a seal, a water faucet valve, a tool, a mold, and a hard disk.

As described above, with regard to the application of the ceramic coating or DLC film as means for surface modification, a low-friction hard film is formed on a surface of a base material. Typically, the ceramic coating or DLC film is not likely to be damaged compared to the solid lubricant. In addition, particularly, the DLC film contains carbon as a main component, and thus an effect on the human body or environment becomes less. However, there is a problem in that the DLC film is opaque, and the base material on which the film is formed is colored. In addition, thermal conductivity is as low as 0.2 to 30 W/mK, and thus in a case where heat dissipation is important for suppression of abrasion, there is a problem in the DLC film. In addition, the DLC film is a hard material, and thus in a case where a sliding counterpart is a soft material, there is a problem in that the DLC film abrades the counterpart (counterpart aggressiveness). Generally, the hard material is lacking affinity, and thus it is difficult to transition from initial (strict) abrasion to slight (mild) abrasion. Generally, the DLC film is weak against a high temperature, and thus there is also a problem in that the DLC film cannot be used at 200 to 300°C or higher.

On the other hand, it is known that a diamond thin film obtained by a chemical vapor deposition (CVD) method and the like functions as a solid lubricating film. However, generally, the CVD diamond has a rough surface, and thus it is necessary for the surface to be polished so as to obtain a smooth surface. Therefore, it is difficult or impossible to use the CVD diamond in an application other than a flat plane. In addition, it is also known that a diamond thin film having a smooth surface may be obtained without polishing by making the size of crystal that constitutes a thin film as small as several tens of nanometers or less by appropriately selecting CVD growth conditions. However, a high temperature of 800 to 400°C is necessary to obtain the diamond film in any case, and thus there is a problem in that a base material on which a film is formed is restricted. In addition, a film is formed at a high temperature, and thus there is also a problem in that the diamond film that is formed has a tendency to be peeled off due to an internal stress that remains inside the film. In addition, there is a problem in that direct coating is very difficult with respect to an iron-based base material that is particularly important in practical use.

To overcome the above-described problems, a polycrystalline diamond thin film that may be formed at a low temperature, or a new carbon film is developed and is known already.

For example, PTL 1 suggests that a base body polished with diamond particles or a base body uniformly coated with diamond particles having a size of approximately 0.05 to 1 $\mu$m is disposed in the vicinity of plasma for diamond thin film deposition, plasma containing a gas mixture that is mainly composed of hydrogen and methane and includes carbon dioxide as necessary is generated at a base body temperature of 600°C or lower under a pressure of 1 to 15 Torr, and a diamond thin film having adhesion with respect to the base body is deposited on the base body.

In addition, PTL 2 suggests a laminate in which a carbon aggregate film having a thickness of 2 nm to 100 $\mu$m is provided on a substrate. The carbon aggregate film is obtained by aggregating carbon particles having an approximate spectrum curve obtained by superimposing, on a peak fitting curve A at a Bragg angle ($2\theta \pm 0.3°$) of 43.9° in an X-ray diffraction spectrum by CuK$\alpha_1$ rays, a peak fitting curve B at 41.7° and a baseline.

Further, PTL 3 discloses a carbon film laminate including a substrate, a carbon film, and an adhesion reinforcing layer. The carbon film is formed by using the following method of forming a carbon film. In the method, a carbon-containing gas and a hydrogen gas are supplied as a raw material gas in a down-flow manner toward a base material inside a reaction vessel so as to generate plasma, a silicon-containing gas is supplied into the plasma toward a substrate, and a substrate temperature is set to 600°C or lower. In the carbon film, very fine carbon particles having a particle size of substantially the same size are present in a film thickness direction, generation of impurities such as amorphous carbon and graphite that are generated at grain boundaries of the carbon particles and/or gaps between the carbon particles along with generation of the carbon particles is suppressed, and a material that suppresses growth of the carbon particles is present. The adhesion reinforcing layer is provided between the substrate and the carbon film to increase adhesion between the carbon film and the substrate.

Citation List

Patent Literature

[PTL 1] Japanese Unexamined Patent Application, First Publication No. H10-095694
[PTL 2] PCT International Publication No. WO2005/103326
[PTL 3] PCT International Publication No. 2007/4647

Non-Patent Literature

[NPL 1] Surface and Coatings Technology Vol. 57, pp. 155-162 (1993).
[NPL 2] Diamond and Related Materials Vol. 7,pp. 1291-1302 (1998).

Summary of Invention

Technical Problem

The present inventors have confirmed that when using the methods disclosed in PTL 2 and PTL 3, coating of the carbon film is possible with respect to various base materials, particularly, an iron-based base material in which coating of the carbon film is very difficult in the related art. Further, from a film formation test and a friction and abrasion characteristic test which are carried out by using the methods disclosed in PTL 2 and PTL 3, the present inventors have revealed that development of a method of forming a carbon film, in which adhesive strength is satisfactory, friction and abrasion are low, and counterpart aggressiveness is low, with good reproducibility is a problem.

Generally, with regard to friction between two kinds of materials, in a case where a difference in hardness is present between the materials, abrasion on a hard material is less, and a soft material is one-sidedly abraded. In the abrasion phenomenon, in a case where reaction, corrosion, and the like do not occur at an interface (frictional surface) of the two materials, adhesive abrasion due to shearing of an adhesive portion at an interface, and abrasive wear that occurs when the hard material cuts a soft counterpart surface become main causes of the abrasion. In a carbon film, the adhesive abrasion is small to an approximately ignorable degree, and the abrasive wear becomes a main cause of friction and counterpart surface abrasion. That is, when the abrasive wear is great, abrasion of a frictional counterpart member increases, and counterpart aggressiveness increases.

The abrasive wear occurs when a hard material grinds off a frictional surface of a soft material during friction between the hard material and the soft material. An amount (volume) of a counterpart material that is ground-off is determined by a surface profile of the grinding side (hard material), and a yield shearing pressure (or Vickers hardness) of a ground-off side (soft material). That is, when the counterpart materials are the same as each other, as an angle of the tip of unevenness in a surface is small, the amount increases. That is, as sharp unevenness is present in much of the frictional surface, the amount increases. In addition, when the surface is rough, ground scraps may adhere to a surface of the hard material, and thus deterioration in frictional characteristics (increase in a friction coefficient and an abrasion amount) may be caused in some cases. Further, in a case where the hard material is a thin film on a base material, when peeling occurs due to friction, debris particles of the peeled thin film enters between frictional surfaces, and thus ternary abrasive wear occurs and strong abrasion and an increase in a friction coefficient occur.

When iron-based materials such as steel iron and stainless steel that are important materials in consideration of the application are taken as an example, a friction coefficient with a carbon film becomes 0.1 or less in the air, at room temperature, and under a non-lubrication environment, and thus the friction coefficient is less than or equal to that of the DLC film. However, with regard to counterpart aggressiveness, the iron-based materials are not superior to the DLC film. In addition, in some cases such as high load, adhesive strength of the carbon film becomes deficient, and thus ternary abrasive wear occurs, or adhesion of a counterpart material occurs. As a result, friction coefficient increase, abrasion of a counterpart material increases, or peeling of the carbon film is promoted.

To solve the problems, it is necessary to decrease the friction coefficient and counterpart aggressiveness by controlling a surface profile of the carbon film, and it is necessary to improve adhesive strength at an interface of the carbon film laminate including the carbon film and the base material thereof.

The invention has been made in consideration of the above-described circumstances in the carbon film, and an object thereof is to provide a laminate having a sliding and frictional surface with low friction, long operational lifespan, high flatness, low counterpart aggressiveness, and high accuracy by providing a carbon film which has satisfactory adhesive strength with good reproducibility compared to a carbon film of the related art, and has a new function such as a surface structure having low counterpart aggressiveness, and by using high adhesiveness to a base material, hardness, surface flatness, abrasion resistance, low friction, low counterpart aggressiveness, and high thermal conductivity which are provided to the carbon film without using a liquid lubricant and the like. In addition, another object of the invention is to provide a method of manufacturing the laminate.

Solution to Problem

To accomplish the above-described object, fluorine (F) atoms are contained in a carbon film of the invention. Since the fluorine atoms are contained in the carbon film, the containing of the fluorine atoms in the carbon film is realized by adding a slight amount of carbon fluoride-based gas to a raw material gas during a manufacturing process by plasma CVD. Examples of the carbon fluoride-based gas include a methane fluoride ($CF_4$) gas, a trifluoromethane ($CHF_3$) gas, a tetrafluoroethylene ($C_2F_4$) gas, and the like.

With regard to synthesis of a diamond film by CVD in the related art, it is known that when halogenated carbon such as $CF_4$ or halogenated hydrocarbon is added to a raw material gas, reinforcement of adhesive strength of a diamond film with respect to a base material or a decrease in surface roughness may be realized (for example, refer to NPL 1 and NPL 2). In NPL 1 and NPL 2, a surface of the base material is cleaned or activated due to a chemical effect of the halogenated carbon or halogenated hydrocarbon, and thus adhesion of the diamond film that is deposited on the surface is increased. In addition, along with the effect, a nucleus formation density of diamond is increased due to activation of the surface of the base material, and according to this, surface roughness of a diamond thin film that is deposited decreases, and thus satisfactory flatness may be obtained.

However, in the carbon film laminate of the invention, reinforcement of adhesion between the carbon film and the base material and a decrease in surface roughness by addition of the carbon fluoride-based gas are obtained by a mechanism and an effect that are completely different from the case of the diamond film. In the carbon film laminate of the invention, the adhesion reinforcement and the decreases in surface roughness are realized by making the thickness of an adhesion reinforcing layer optimal due to an addition effect of the carbon fluoride-based gas. Further, a spatial frequency distribution of unique surface unevenness which exhibits not only the decrease in surface roughness but also low counterpart aggressiveness is realized due to the addition effect of the carbon fluoride-based gas. The addition effect of the carbon fluoride-based gas is particularly large with respect to base materials such as an iron-based based material including stainless steel, a silicon base material, a glass base material, and the like.

As described above, in PTL 3, the carbon film laminate (refer to FIG. 24 and FIG. 25 of PTL 3) including the substrate, the carbon film, and the adhesion reinforcing layer is obtained by using the following method of forming the carbon film. In the method, a carbon-containing gas and a hydrogen gas are supplied as a raw material gas in a down-flow manner toward a substrate inside a chamber so as to generate plasma, and a silicon-containing gas generated by exposing the silicon-containing gas or bulky silicon or $SiO_2$ to the plasma is supplied into the plasma toward the substrate, and a substrate temperature is set to 600°C or lower. In the carbon film, very fine carbon particles in a particle size of substantially the same size are present in a film thickness direction, generation of impurities such as amorphous carbon and graphite that are generated at grain boundaries of the carbon particles and/or gaps between the carbon particles along with generation of the carbon particles is suppressed, and a material that suppresses growth of the carbon particles is present. The adhesion reinforcing layer is provided between the substrate and the carbon film to increase adhesion between the carbon film and the substrate.

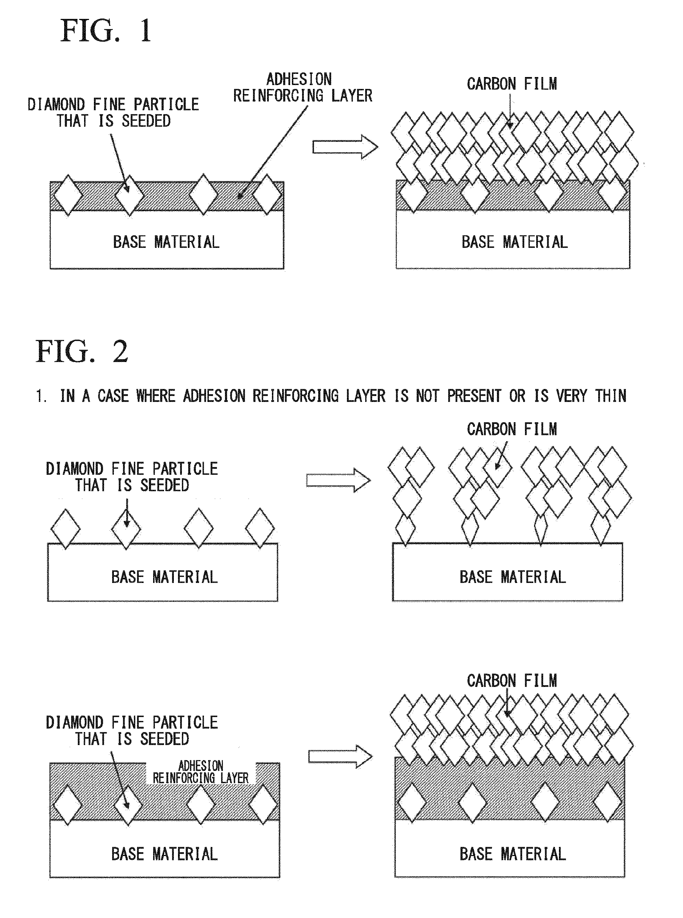

From results of examination on a more detailed structure and a forming process of the adhesion reinforcing layer disclosed in the Patent Literature, it becomes obvious that an interface structure of the laminate including the carbon film and the base material which have satisfactory adhesive strength in a thickness direction of the adhesion reinforcing layer is similar to a structure shown in FIG. 1.

That is, in a case where the adhesion reinforcing layer is formed to completely bury gaps between diamond fine particles which adhere to a surface of the base material and have a particle size of 5 to 50 nm, and the diamond fine particles are formed to slightly protrude from the adhesion reinforcing layer, satisfactory adhesive strength may be obtained. However, it is not necessary for all of the diamond fine particles to protrude, and at least one or more diamond fine particles may protrude from the adhesion reinforcing layer. This is because the adhesive strength of the carbon film that is formed is obtained by an anchor effect of each of the diamond fine particle that is seeded and the adhesion reinforcing layer.

On the contrary, as shown in FIG. 2, in a case where the adhesion reinforcing layer is not present or is very thin, the anchor effect due to the adhesion reinforcing layer is not present, and thus satisfactory adhesive strength may not be obtained. In addition, in a case where the adhesion reinforcing layer is excessively thick, since the anchor effect due to the diamond fine particles may not be obtained, it becomes obvious that satisfactory adhesion strength may not be obtained.

Further, details of processes of forming the adhesion reinforcing layer and the carbon film are examined.

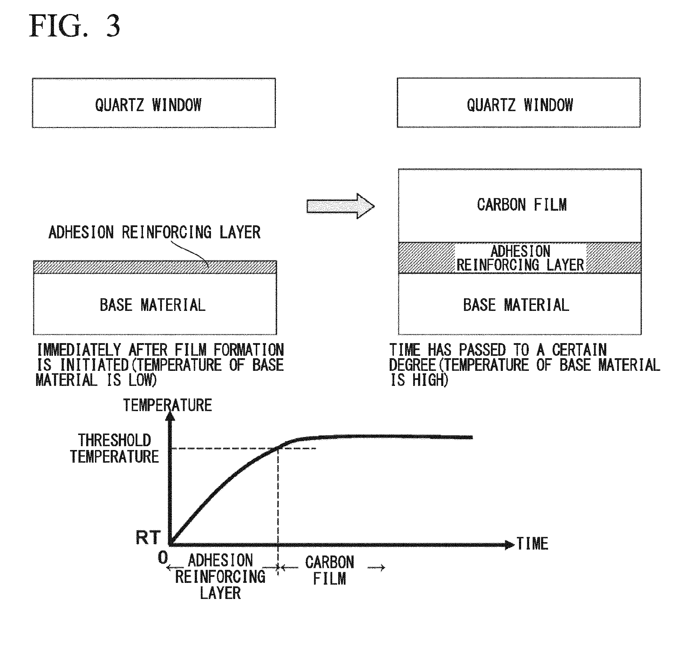

FIG. 3 shows a view illustrating results of the examination. Film formation is initiated from a point of time at which a temperature of the base material is room temperature (RT). The base material is heated by plasma and thus the temperature of the base material gradually increases. Before the temperature of the base material reaches an arbitrary threshold temperature from room temperature, a silicon oxide layer ($SiO_x$, x = 1 to 2) that is the adhesion reinforcing layer is preferentially formed on a surface of the base material. When the base material is further heated and the temperature of the base material becomes the threshold temperature or higher, the carbon film is deposited at this time. Although being slightly different depending on a kind of the base material, the threshold temperature is 200 to 300°C. It becomes obvious that the laminate of the adhesion reinforcing layer and the carbon film is formed through the formation process.

In a case where the film formation is initiated after heating the base material in advance before initiation of the film formation to the threshold temperature or higher, for example, 300°C or higher, the adhesion reinforcing layer is not formed, and thus adhesive strength of the carbon film to the base material becomes extremely weak. This fact is obviously different from the known adhesion reinforcing mechanism by addition of carbon fluoride-based gas such as $CF_4$ which is disclosed, for example, in NPL 1 and the like. This is because the effect of cleaning or activation of a surface of the base material due to the carbon fluoride-based gas is reinforced along with an increase in a temperature of the base material. In addition, an obvious increase in nucleus formation density as disclosed in NPL 1 and NPL 2 is also not observed.

Here, the main factors, which determine the thickness of the adhesion reinforcing layer that is important for satisfactory adhesive strength, are as follows.

    1. Profile of rising the temperature of the base material
    2. Supply rate of the silicon-containing gas from a quartz window
    3. Effect of removing the adhesion reinforcing layer by plasma etching

The above-described factors are affected by a state of a film forming device. Particularly, it can be seen that the factors are greatly affected by a polluted state of a microwave transmitting window, microwave power, a gas pressure, a temperature of cooling water for a reaction vessel, and the like, and thus it is difficult to form the adhesion reinforcing layer having an appropriate thickness (5 to 50 nm) with good reproducibility. Particularly, in many cases, the adhesion reinforcing layer thicker than an appropriate thickness is formed, and thus satisfactory adhesive strength is not obtained.

In the invention, the present inventor has found a method of forming the adhesion reinforcing layer having a thickness appropriate for obtaining satisfactory adhesive strength on the basis of the above-described findings. That is, the present inventors have extensively studied to prepare the carbon film having the above-described characteristics, and as a result, they have found that when carrying out a plasma CVD treatment after adding a carbon fluoride-based gas to a raw material gas, the effect of removing the adhesion reinforcing layer may be obtained due to a silicon oxide ($SiO_x$, x = 1 to 2) etching effect by fluorine plasma. In addition, the present inventors have found that the magnitude of the effect of removing the adhesion reinforcing layer may be controlled by controlling an added concentration of the carbon fluoride-based gas in the raw material gas, and according to this, the thickness of the adhesion reinforcing layer may be appropriately controlled. Further, even when the temperature of the substrate is raised and it enters a state in which the carbon film is preferentially deposited, when the carbon fluoride-based gas is continuously added, an effect in which a deposition rate of the carbon film is improved, and surface roughness of the carbon film after deposition and counterpart aggressiveness are decreased is obtained. The present inventors have found that according to this effect, a carbon film laminate having very satisfactory adhesive strength and a low-counterpart-aggressiveness surface may be formed without deteriorating hardness, transparency, and thermal conductivity of the carbon film. In addition, the present inventors have found that in a case of adding the carbon fluoride gas in a concentration range capable of obtaining the effect to the raw material gas, fluorine atoms in a concentration of $1 \times 10^{19}$ atoms/cm$^3$ or more are contained in the adhesion reinforcing layer, and fluorine atoms in a concentration of $1 \times 10^{19}$ to $1 \times 10^{21}$ atoms/cm$^3$ are contained in the carbon film. The present inventors have accomplished the carbon film laminate of the invention on the basis of the above-described findings.

The invention has been accomplished on the basis of the above-described findings, and has the following configurations.

[1] According to an aspect of the invention, there is provided a carbon film laminate including a base material, a carbon film adhesion reinforcing layer which is provided on the base material and which is formed from silicon oxide ($SiO_x$, x= 1 to 2) containing fluorine atoms (F) in a concentration of $1 \times 10^{19}$ atoms/cm$^3$ or more, and a carbon film that is formed on the carbon film adhesion reinforcing layer. The carbon film contains fluorine atoms in the film in a concentration of $1 \times 10^{19}$ to $1 \times 10^{21}$ atoms/cm$^3$ and has an approximate spectrum curve obtained by superimposing, on a peak fitting curve A at a Bragg angle ($2\theta \pm 0.5°$) of 43.9° in an X-ray diffraction spectrum by CuK$\alpha_1$ rays, a peak fitting curve B at 41.7° and a baseline (here, the fitting curve A is expressed with a curve of a Pearson VII function, the fitting curve B is expressed with a curve of an asymmetric normal distribution function, and the baseline is expressed with a linear function).

[2] In the carbon film laminate according to [1], the surface roughness Ra of the carbon film may be 20 nm or less.

[3] In the carbon film laminate according to [1] or [2], in a power spectrum of a surface roughness contour curve of the carbon film, a scaling exponent according to a power law may be 3 to 5.

[4] In the carbon film laminate according to any one of [1] to [3], a friction coefficient of the carbon film at a temperature of 0 to 50°C and humidity of 10 to 100% in the air may be 0.01 to 0.1.

[5] In the carbon film laminate according to any one of [1] to [4], a light transmittance of the carbon film at a wavelength of 400 to 800 nm may be 55% or more.

[6] In the carbon film laminate according to any one of [1] to [5], a light transmittance of the carbon film at a wavelength of 400 to 800 nm may be 80% or more.

[7] In the carbon film laminate according to any one of [1] to [6], thermal conductivity of the carbon film may be 10 W/mK or more, and resistivity at 100°C may be $1 \times 10^7$ Ωcm or more.

[8] According to another aspect of the invention, there is provided a method of manufacturing the carbon film laminate according to any one of [1] to [7]. The method includes a process of treating a surface of a base material with ultrasonic waves, a process of allowing a nanocrystal diamond to adhere on the base material that is treated with ultrasonic waves, and a film forming process of carrying out a CVD treatment on the base material to which the nanocrystal diamond adheres to form a carbon film. The film forming process is carried out by disposing the base material at a position at which an electron temperature of plasma becomes 0.5 to 3 eV by using a hydrogen gas, a hydrocarbon gas, an oxygen-containing gas, and a carbon fluoride-based gas.

[9] According to still another aspect of the invention, there is provided a lubricant including the carbon film laminate according to any one of [1] to [7].

Advantageous Effects of Invention

The laminate of the invention has high adhesiveness to the base material, hardness, surface flatness, transparency, thermal conductivity, low friction coefficient, a low wear rate, and low counterpart aggressiveness which are provided to the carbon film. Accordingly, when using the laminate of the invention, a laminate having a low-friction and low-abrasion frictional surface may be provided without using lubricating oil, a solid lubricant, and the like. According to the method of depositing the carbon film of the invention, friction and abrasion characteristics of a surface of the base material may be improved, as well as a non-colored and high-heat-dissipation sliding surface may be provided due to transparency and thermal conductivity of the carbon film.

Brief Description of Drawings

FIG. 1 is a cross-sectional view illustrating an interface structure of a laminate including a carbon film and a base material which have satisfactory adhesive strength according to the invention.

FIG. 2 is a cross-sectional view illustrating an interface structure of a laminate including a carbon film and a base material in a case where satisfactory adhesive strength may not be obtained.

FIG. 3 is a view illustrating the outline of a process of forming the adhesion reinforcing layer and the carbon film in the carbon film laminate of the invention.

FIG. 4 is a view illustrating a configuration of a device of manufacturing the laminate including the carbon film and the base material of the invention.

FIG. 5 is a Raman spectrum chart illustrating formation of a carbon film onto an SUS440C base material.

FIG. 6 is a view illustrating an X-ray diffraction spectrum of a carbon film that is an example of the invention by $CuK\alpha_1$ X-rays, and a peak pitting result.

FIG. 7 is a view illustrating a surface profile contour curve of the carbon film of the invention.

FIG. 8 is a view illustrating a power spectrum of the surface profile contour curve of the carbon film of the invention.

FIG. 9 is a view illustrating a power spectrum of a surface profile contour curve of an SUS440C stainless steel base material before depositing the carbon film in the carbon film laminate of the invention.

FIG. 10 is a view illustrating a variation of a friction coefficient over time in the air without lubrication with respect to an SUS440C ball (radius: 3/16 inches) of the carbon film laminate of the invention.

FIG. 11 is a view illustrating comparison of a friction coefficient in the air without lubrication between the carbon film laminate of the invention and laminates using a commercially available DLC film.

FIG. 12 is a view illustrating abrasion (counterpart aggressiveness) of a counterpart material (SUS440C) in the air without lubrication with respect to the carbon film laminate of the invention, and the laminates using the commercially available DLC film.

FIG. 13 is a view illustrating an unevenness model having a wavelength $\lambda$ (a wavenumber k = $1/\lambda$), an amplitude "a" of height, and an angle $\theta$ of the tip.

FIG. 14 is a view illustrating a relationship between a power law exponent and a wear rate of a friction counterpart material (SUS440C) in the power spectrum of the surface profile contour curve of the carbon film laminate of the invention and the commercially available DLC film laminates.

FIG. 15 is a secondary ion mass analysis spectrum chart illustrating the density of the number of atoms of fluorine atoms in the carbon film and the adhesion reinforcing layer of the carbon film laminate of the invention.

Description of Embodiments

The carbon film of the invention is a carbon film which is constituted by very fine carbon particles and in which generation of impurities such as amorphous carbon and graphite that are generated at grain boundaries of the carbon particles and/or gaps between the carbon particles along with generation of the carbon particles is suppressed, and a material that suppresses growth of the carbon particles is present. The carbon film contains fluorine atoms in the film in a concentration of $1\times10^{19}$ to $1\times10^{21}$ atoms/cm$^3$. The particle size of the carbon particles is in a range of approximately 1 to 1000 nm. In the range of the particle size, carbon particles having a particle size of substantially the same size of 2 to 200 nm are present in the film thickness direction. Here, "having a particle size of substantially the same size of 2 to 200 nm" represents that in the entirety of carbon particles, 51 % or more particles have a particle size in a range of 2 to 200 nm. Further, the carbon film laminate of the invention includes an adhesion reinforcing layer which is provided at an interface between a base material and the carbon film and which is formed from silicon oxide ($SiO_x$, x= 1 to 2). The adhesion reinforcing layer contains fluorine atoms in a concentration of $1\times10^{19}$ atoms/cm$^3$ or more, and preferably in a concentration of $1\times10^{19}$ to $1\times10^{21}$ atoms/cm$^3$.

In the carbon film of the invention, when the concentration of the fluorine atoms in the film is less than $1\times10^{19}$ atoms/cm$^3$, a power law scaling exponent of the surface roughness contour curve power spectrum is less than 3, and thus a decrease in counterpart aggressiveness does not occur. In addition, when the concentration exceeds $1\times10^{21}$ atoms/cm$^3$, growth of the carbon film is suppressed, and thus the carbon film is not generated. In addition, in a case where the concentration of the fluorine atoms in the adhesion reinforcing layer is less than $1\times10^{19}$ atoms/cm$^3$, the adhesion reinforcing effect disappears, and even when containing fluorine atoms of $1\times10^{21}$ atoms/cm$^3$ or more, the

adhesion reinforcing effect is not further reinforced.

The carbon film of the invention may be obtained by employing specific manufacturing device and manufacturing conditions disclosed in PTL 3. Further, it is necessary for the device to include a unit that supplies a carbon fluoride-based gas such as a $CF_4$ gas as an additive element for improving the adhesive strength to the base material of the carbon film and for improving surface flatness, low friction, and low counterpart aggressiveness. As operational conditions of the unit, it is necessary to select a concentration or a molar ratio of a raw material gas, a reaction time, and the like, and to carry out the operation at a relatively low temperature.

A mixing ratio of a mixed gas which is suitable for film formation is different depending on a kind of the base material, a surface treated state, and the like, but in a hydrocarbon gas/total mixed gases, the concentration of the carbon-containing gas is 0.5 to 10 mol%, and preferably 1 to 5 mol%. When the concentration of the hydrocarbon gas is more than the above-described range, a problem such as a decrease in an optical transmittance of the carbon film occurs, and thus this concentration is not preferable. Examples of the hydrocarbon gas include a methane ($CH_4$) gas, an ethylene ($C_2H_4$) gas, an acetylene ($C_2H_2$) gas, and the like. The addition of the carbon fluoride-based gas is significantly effective for a decrease in surface roughness of the carbon film, a decrease in a friction coefficient, a decrease in counterpart aggressiveness, and reinforcement of adhesion with the base material. A concentration of the carbon fluoride-based gas is preferably 0.1 to 5 mol% in the total mixed gases, and more preferable 0.1 to 1 mol%. When the concentration of the $CF_4$ gas is more than the above-described range, the effect is not reinforced, and a problem of a decrease in the optical transmittance of the carbon film and the like occur. Therefore, this concentration is not preferable. In addition, it is preferable to add an oxygen-containing gas as an additive gas to the mixed gas. Examples of the oxygen-containing gas include carbon dioxide ($CO_2$) gas, carbon monoxide (CO) gas, oxygen ($O_2$), and the like. These gases operate as an oxygen source, and exhibit an operation of removing impurities in a plasma CVD treatment. An added amount of the oxygen-containing gas is preferably 0.5 to 10 mol% in the total mixed gases, and more preferably 1 to 5 mol%.

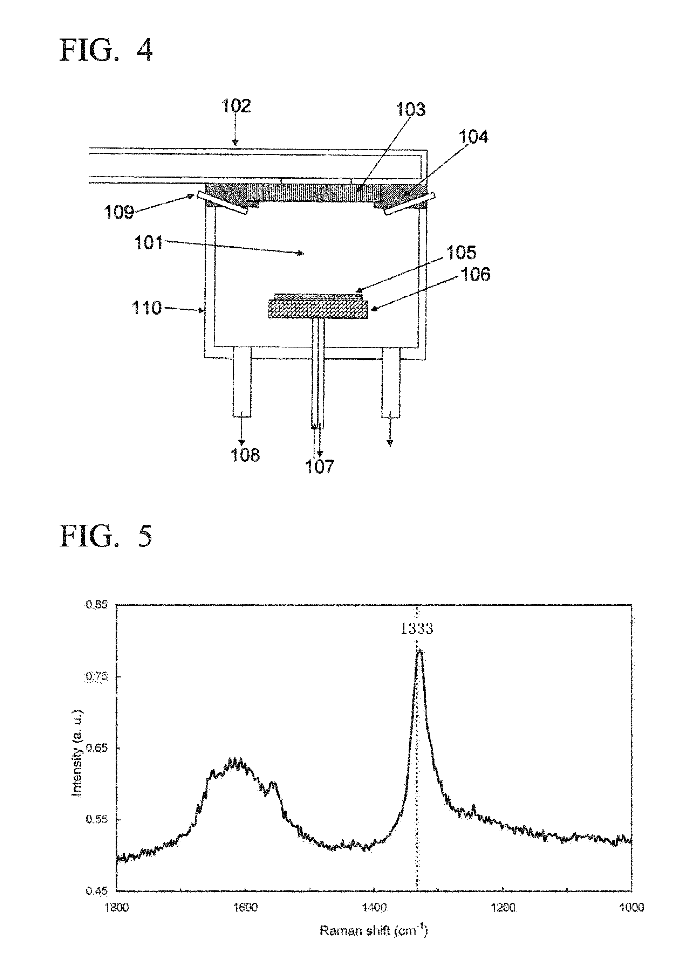

FIG. 4 illustrates an example of a device that is used to form a laminate of the carbon film and an iron-based base material. In the drawing, a reference numeral 101 represents a microwave plasma CVD reaction furnace (hereinafter, simply referred to as a "plasma generation chamber"). A reference numeral 102 represents a rectangular waveguide tube with a slot configured to introduce microwaves to the plasma generation chamber 101. A reference numeral 103 represents a quartz member configured to introduce microwaves to the plasma generation chamber 101. A reference numeral 104 represents a metallic support member that supports the quarts member. A reference numeral 105 represents a base material on which a film is to be formed. A reference numeral 106 represents a sample stage on which the base material on which a film is to be formed is installed, and the sample stage is provided with a vertical movement mechanism and a cooling mechanism for the base material on which a film is to be formed. A reference numeral 107 represents water supply and drainage of cooling water. A reference numeral 108 represents exhausting. A reference numeral 109 represents a plasma generation gas introduction unit. A reference numeral 110 represents a reaction furnace in which a plasma CVD treatment is carried out.

The plasma generation by using the device is carried out as follows. The plasma generation chamber 101 is evacuated by an exhaust device (not shown). Subsequently, a plasma generation gas is introduced to the plasma generation chamber 101 at a predetermined flow rate through the gas introduction unit 109 for the plasma generation chamber. Next, a pressure adjusting valve (not shown) provided in the exhaust device is adjusted to maintain the inside of the plasma generation chamber 101 at a predetermined pressure. Microwaves with desired power are supplied from a device (not shown) that generates microwaves of 2.45 GHz into the plasma generation chamber 101 through the waveguide tube 102 with a slot and the quartz member 103 to generate plasma inside the plasma generation chamber 101. Radical particles in the plasma which become a source of film formation may be supplied in a down flow manner by moving the radical particles from the bottom surface (on a CVD treatment reaction furnace side) of the quartz member 103 for introduction of the microwaves that becomes the origin of plasma generation toward the base material to reach the surface of the base material installed on the sample stage in an approximately uniform manner.

According to the invention, a laminate of the carbon film and each of various base materials may be formed. In a surface profile contour curve of the carbon film, the power spectrum density follows a power law at least in a spatial period equal to or larger than a range of 100 nm to 1 $\mu$m, and an exponent thereof exhibits a very large value of 3 to 5. This represents that the carbon film has characteristics significantly different from that of other carbon particles such as diamond and other carbon films. In addition, in a Raman scattering spectroscopy spectrum (excitation wavelength: 244 nm), as shown in FIG. 5, a clear peak is found in the vicinity of a Raman shift of 1333 cm$^{-1}$, and a full width at half maximum (FWHM) is 10 to 40 cm$^{-1}$.

In addition, from observation of a cross-section of a film by using a transmission electron microscope with high resolution, it can be seen that the film is formed in such a manner that crystalline carbon particles having a particle size of 1 nm to several tens of nm are closely packed without a gap, and the film has characteristics in that a particle size distribution does not vary (an average particle size distribution is substantially the same) at an interface between the film and substrate, in the film, and at the vicinity of an outermost surface of the film. The particle size of the particles is preferably 1 to 100 nm, and more preferably 2 to 20 nm.

The film obtained in this manner is excellent in flatness and adhesiveness, and the surface roughness Ra thereof is 20 nm or less. In some cases, the film is as flat as 3 nm or less. In addition, adhesive strength measurement is carried out by a scratch tester using a diamond needle having a tip diameter of 200 $\mu$m, and it can be seen that peeling strength of 5 N or more can be obtained. High transparency of the carbon film of the invention is realized by the above-described film thickness and the surface roughness, and the film that is obtained has excellent optical properties, in which such as transparency is excellent, a refractive index is 1.5 or more, and birefringence is hardly exhibited. In addition, the carbon film has excellent electrical properties such as high electrical insulating properties. For example, resistivity at 100°C is $10^7$ $\Omega$cm or more at a temperature of 100°C.

Examples

Hereinafter, the invention will be described in more detail with reference to examples and the like, but the invention is not limited to the examples and the like.

In the invention, a pre-treatment is carried out with respect to a base material, and then a plasma CVD treatment is carried out. As the pre-treatment, the base material was immersed in a dispersed solution of diamond ultrafine particles such as nanocrystal diamond particles, and then an ultrasonic treatment was carried out to allow the diamond ultrafine particles to adhere a surface of the base material. This method is known in the related art and is described in detail in PTL 2 and PTL 3.

A plasma CVD treatment time is 1 to 20 hours. In addition, although being different depending on a base material, a treatment temperature is 100 to 500°C. If a temperature of the base material is increased, the damage to the base material due to plasma also increases. In addition, in an iron-based base material such as steel, there is a problem of deterioration of the base material such as softening due to a high temperature. On the other hand, properties of the laminate of the base material and the carbon film vary according to the temperature of the base material during the plasma CVD treatment. For example, as the temperature of the base material is raised, adhesiveness between the base material and the carbon film has a tendency to increase. Accordingly, it is necessary to select an optimal temperature, according to a kind of the base material, and a practical use of the base material.

(Formation of Carbon Film)

As the base material, a block-shaped SUS440C stainless steel was used. The shape of the stainless steel base material was 16 mm $\times$ 6 mm $\times$ 10 mm (height). One surface of 16 mm $\times$ 6 mm was mirror-polished and was set as a carbon film forming surface. Surface roughness Ra of the film forming surface was 3 to 4 nm. The stainless steel base material was washed with CS gasoline to remove oily components on a surface. Then, the stainless steel base material was subject to an ultrasonic treatment in isopropanol, and then the ultrasonic treatment was carried out in a mixed solution of CS gasoline and acetone. Furthermore, the ultrasonic treatment was carried out in acetone. Then, the stainless steel base material was dried, and the pre-treatment was carried out to allow the nanocrystal diamond particles dispersed in water to adhere to the stainless steel base material. Here, the stainless steel base material was immersed in the dispersed solution, an ultrasonic washer was operated, and then the base material was immersed in ethanol to carry out ultrasonic washing. Then, the base material was taken out from ethanol and was dried. In this manner, a stainless steel base material to which the nanocrystal diamond particles adhered was obtained. The adhesion of the nanocrystal diamond particles to the stainless steel base material is carried out by a physical force during the ultrasonic washing treatment, and parts of the particles are buried in a surface of the base material. The diamond particles that adhered to the stainless steel base material serve as seed crystals for carbon film growth during the plasma CVD treatment.

As described below, the carbon film was formed on the stainless steel base material, which was subjected to the pre-treatment, by using a plasma CVD device shown in FIG. 4.

A gas that was used for the CVD treatment was composed of 90 mol% of hydrogen, 5 mol% of a methane gas, 5 mol% of carbon dioxide, and 0.1 mol% of a $CF_4$ gas. Plasma was generated at a gas pressure of 20 Pa, the base material was disposed at a position which was spaced from a quartz window by 125 mm and in which an electron temperature of plasma was 2.6 eV, and the plasma CVD treatment was carried out for 20 hours. At this time, a dummy base material which was composed of the same material as the base material and had the same shape as the base material was prepared. And a thermocouple was brought into contact with the top surface of the dummy base material, and was fixed to the top surface of the dummy base material, which was irradiated with plasma. The dummy base material was disposed in the vicinity of the base material for film formation, and measurement of a base material temperature was carried out. The base material temperature after the plasma CVD treatment was approximately 360°C. According to the plasma CVD treatment, a carbon film having a thickness of approximately 1.8 $\mu$m was deposited on the surface of the base material.

A Raman scattering spectroscopy spectrum (excitation wavelength: 244 nm) of the laminate of the stainless steel base material and the carbon film which was prepared by the above-described method is shown in FIG. 5.

As shown in FIG. 5, in the Raman scattering spectrum of the laminate, a peak in the vicinity of a Raman shift of 1333 cm$^{-1}$ is clearly recognized, and deposition of the carbon film becomes obvious. The same measurement was carried out with respect to a plurality of other samples prepared by the same method. From the measurement, it could be seen that the peak was present in a range of 1320 to 1340 cm$^{-1}$, and the peak entered a range of 1333±10 cm$^{-1}$. In addition, a broad peak found in the vicinity of the Raman shift of 1600 cm$^{-1}$ represents the presence of a sp$^2$ bounding component of carbon. When a percentage of the component increases, for example, a peak in the vicinity of 1600 cm$^{-1}$ becomes much stronger than a peak in the vicinity of 1333 cm$^{-1}$, and the film is colored opaque black. In the case of FIG. 5, the height of the peak is as small as 1/2 or less of the peak at 1333 cm$^{-1}$, and it can be seen that the film is transparent as described below. A full width at a half maximum (FWHM) of a peak located in the vicinity of the Raman shift of 1333 cm$^{-1}$ was approximately 33 cm$^{-1}$. The same measurement was carried out with respect to a plurality of other samples. From the measurement, it could be seen that the FWHM was in a range of 10 to 40 cm$^{-1}$.

(Measurement of X-Ray Diffraction)

The carbon film laminate was observed by X-ray diffraction. Hereinafter, details thereof will be described.

An X-ray diffraction device that was used was an X-ray diffraction device RINT XRD-DSCII manufactured by Rigaku Corporation, and a goniometer that was used was UltimaIII horizontal goniometer manufactured by Rigaku Corporation. A multi-purpose sample stage standardized for a thin film was mounted to the goniometer. As for the X-rays, K$\alpha_1$ rays of copper (Cu) were used. The voltage and current that were applied to an X-ray tube were 40 kV and 40 mA. As the X-ray detector, a scintillation counter was used. First, a scattering angle (angle 2θ) was calibrated using a standard sample of silicon. A deviation of the angle 2θ was ± 0.02° or less. Next, a measurement sample was fixed to the sample stage, and the angle 2θ was set to 0°, that is, the intensity of X-ray was measured by the detector. A computer program that was used for the measurement was RINT2000/PC software Windows (registered trademark) version supplied by Rigaku Corporation.

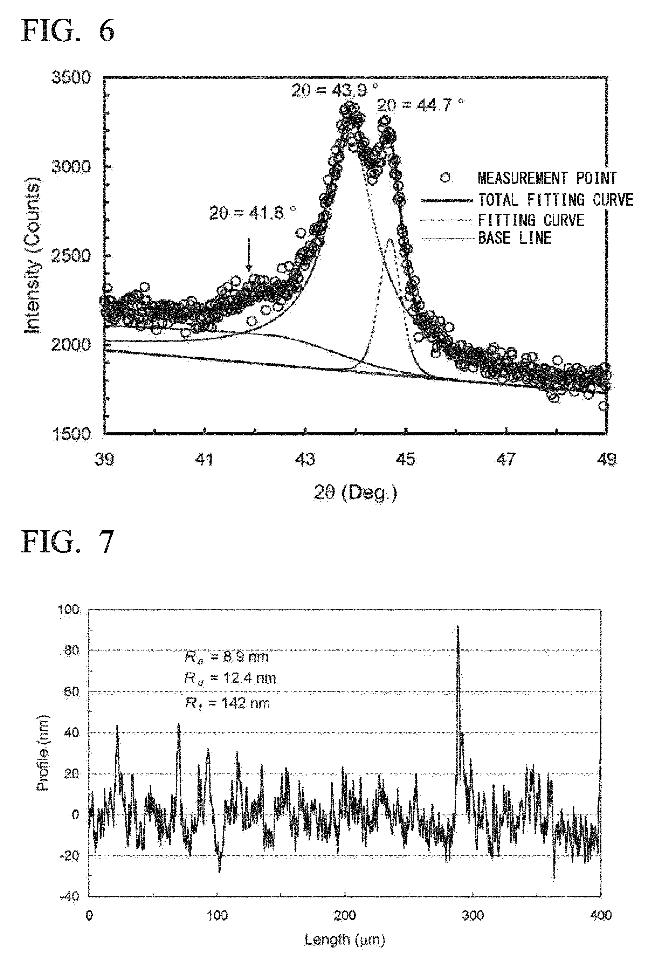

An X-ray diffraction spectrum that was measured is shown in FIG. 6. White circles in the drawing represent measurement points. It can be clearly understood that peaks are present at Bragg angles (2θ) of 43.9° and 44.7°. In addition, it can be seen that a small peak is present at a Bragg angle of 41.8°. The peak at a Bragg angle of 44.7° is a peak of SUS440C stainless steel of the base material. The peaks at 43.9° and 41.8° are peaks of the carbon film deposited on the base material and are peaks peculiar to the carbon film disclosed in PTL 2 and PTL 3. Here, similar to the method disclosed in PTL 2 and PTL 3, when the peaks at 44.7° and 43.9° are approximated by a Pearson VII function curve, the peak at 41.8° is approximated by asymmetric normal distribution function curve, and when these curves are superimposed on each other with a baseline set as a linear function, a satisfactory approximate curve of the X-ray diffraction spectrum may be obtained. At this time, an intensity ratio of the peak at 41.8° to the peak at 43.9° was approximately 12%.

(Measurement of Surface Roughness)

Evaluation of surface roughness was carried out by a stylus surface profilometry device of the laminate of the invention. In this case, evaluation of the surface roughness of the base material was carried out. The surface profile measurement device that was used was a micro-profile measurement device SURFCORDER ET4300 manufactured by Kosaka Laboratory Ltd. As a probe, a diamond stylus having a tip radius of 2 μm, which is standardized for the micro profile measurement device, was used. The measurement was carried out under measurement conditions of an evaluation length of 0.4 mm, a cut-off value of 0.08 mm, a scanning speed of 5 μm/s, and 50 nm step (a value obtained by equally dividing the evaluation length into 8000 parts). Measurement control and analysis of surface profile data that was obtained were carried out using roughness analysis system software standardized for the micro profile measurement device, that is, i-STAR SE Application version 6.72. A resultant surface profile contour curve is shown in FIG. 7. In the drawing, the vertical axis of the contour curve is drawn with an average height set to 0. As shown in FIG. 7, as surface roughness parameters that were obtained from the contour curve, arithmetic mean roughness Ra was 8.9 nm, root mean square roughness Rq was 12.4 nm, and the maximum cross-section height Rt was 142 nm. Although the surface roughness of the carbon film is different depending on deposition conditions of the carbon film, it was confirmed that Ra was in a range of 3 to 20 nm. In addition, the arithmetic mean roughness Ra, the root mean square roughness Rq, and the maximum cross-section height Rt are described in detail, for example, in "JIS B 0601-2001" or "ISO4287-1997".

(Power Spectrum of Surface Roughness)

Analysis for a periodic structure of the surface profile was carried out from the above-described surface profile contour curve of the laminate of the carbon film and the stainless steel base material of the invention. For this analysis, power spectrum of the surface profile contour curve shown in FIG. 7 was obtained. Fast Fourier Transform (FFT) of the contour curve was carried out to obtain the power spectrum. In the total evaluation length of 0.4 mm, 4096 pieces of height data up to 0 to 0.2048 mm were used. The FFT was carried out by spreadsheet software (Microsoft Excel 2002 SP3 supplied by Microsoft Corporation from the USA), and an add-on analysis tool thereof.

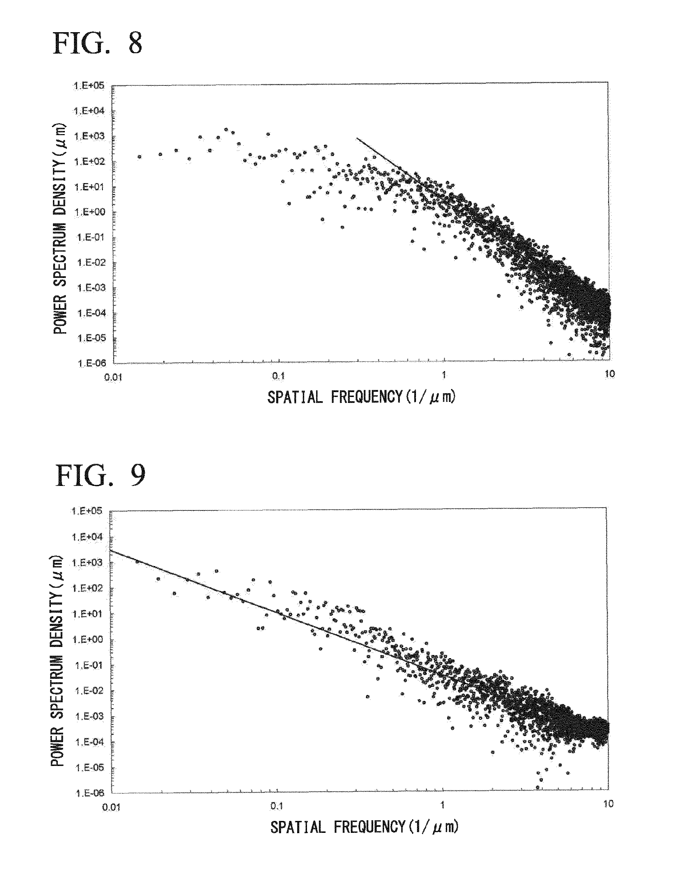

The power spectrum that was obtained is shown in FIG. 8. A measurement length step value (step) $\Delta L$ of the contour curve is 50 nm as described above, the number N of data is 4096, and thus data section $L_0$ is $L_0 = \Delta L \times N = 0.2048$ mm as described above, and a step value $\Delta k = 1/L_0$ of the spatial frequency (wavenumber), which is the horizontal axis of the power spectrum of FIG. 8, is approximately 0.00488 $\mu$m. In addition, a power spectrum density P, which is the vertical axis of FIG. 8, is defined as $P = |F(k)|^2/L_0$. Here, a Fourier component of the contour curve with respect to the wavenumber k ($k = n \cdot \Delta k$: $1 \leq n \leq N$) which is obtained by FFT is set as F(k). However, with regard to the spreadsheet software Excel 2002, in the FFT of an analysis tool, a frequency interval $\Delta k$ is set to 1, and thus if an $n^{th}$ value of an output of the FFT is set to $C_n$, $|F(k)| = |C_n| \cdot \Delta L$. With respect to the FFT and power spectrum, for example, reference may be made to "Introduction to Fourier Analysis by Excel" (SHOKODO CO., LTD.).

In FIG. 8, in the laminate of the carbon film and the SUS440C, it can be seen that in a region in which the spatial frequency is 0.5 to 10 $\mu$m$^{-1}$, the power spectrum density P decreases in a linear relationship against the spatial frequency k. In the drawing, a straight line that is fitted by a least squares method in the region is shown. In FIG. 8, the vertical axis and the horizontal axis are expressed by a logarithmic scale, and exhibition of a linear relationship in both logarithmic graphs represents that the power spectrum density P follows a power law in which $P \propto k^{-\infty}$, and a gradient of the straight line becomes an exponent $\alpha$. In the case of FIG. 8, $\alpha$ is equal to 4.7. In FIG. 9, a power spectrum density of a surface profile contour curve of the SUS440C base material before depositing the carbon film is shown. In this case, over the entirety of the measurement region (spatial frequency of 0.01 to 10 $\mu$m$^{-1}$), the power spectrum density and the spatial frequency are in a linear relationship, and the exponent $\alpha$ is approximately 2.5.

Generally, in a case where the power spectrum density of the surface profile contour curve follows the power law, as the exponent $\alpha$ increases, the surface profile is less complicated and smooth. In a case of the carbon film laminate of the invention, in the laminate of the SUS440C and the carbon film, the power law exponent $\alpha$ of the surface profile power spectrum density of the base material is approximately 2.5, and as a result of forming the laminate, in a range of the spatial frequency of 0.5 to 10 $\mu$m$^{-1}$, $\alpha$ increases to approximately 4.7. This result represents that complication of surface unevenness having a period of the spatial frequency of 0.5 to 10 $\mu$m$^{-1}$ (a wavelength of 0.1 to 2 $\mu$m) decreases due to deposition of the carbon film on the surface of the SUS440C base material, and a surface of the laminate becomes smooth. This becomes a main cause of reduction in the friction coefficient and realization of low counterpart aggressiveness.

(Measurement of Visible Light Transmittance)

Measurement of a transmittance of the carbon film for visible light was carried out. When measuring the transmittance, it is necessary for the base material forming the laminate with the carbon film to be transparent. Accordingly, when measuring the visible light transmittance, a laminate, which was formed by depositing a carbon film on a borosilicate glass wafer substrate having a diameter of 10 cm and a thickness of 1 mm, was used. As a transmittance measuring device, UV/Vis/NTR Spectrometer Lambda 900 manufactured by PerkinElmer Co., Ltd. was used, and measurement of a transmittance in a wavelength region of 300 to 800 nm was carried out. During the measurement, light beams of a light source were divided into two optical paths, and one of the optical paths was aimed at the laminate, and the other optical path was aimed at a glass wafer on which the carbon film was not deposited. According to this, transmittance spectrums of the laminate and the glass substrate were measured at the same time, and a transmittance spectrum of the carbon film itself was obtained by subtracting the spectrum of the glass substrate from the spectrum of the laminate. For measurement and analysis, as computer software for measurement and analysis of the device, UV-WinLab ver. X1.7A manufactured by PerkinElmer Co., Ltd. was used. As a result, when obtaining an average transmittance in the entirety of a visible light region (wavelength of 400 to 800 nm), the average transmittance was approximately 90%, and it was revealed that the carbon film had very high transparency as a non-polished carbon film. Particularly, it could be seen that the carbon film had a transmittance overwhelmingly higher than a typical non-polished diamond thin film.

(Measurement of Thermal Conductivity of Carbon Film)

In the invention, measurement of a thermal conductivity of the carbon film, which constitutes the laminate together with the base material, was carried out by a laser flash method. With regard to the measurement method, a quartz glass was used as the base material. The carbon film was deposited on the quartz glass base material, and then evaluation of the thermal conductivity of the carbon film was carried out. A carbon film having a film thickness of 1 $\mu$m was formed on the quartz glass base material having dimensions of 5 mm $\times$ 5 mm $\times$ 100 $\mu$m (thickness). 30 sheets of the laminate were superimposed to prepare a rectangular parallelepiped sample having dimensions of 5 mm $\times$ 5 mm

× approximately 3 mm (side surface thickness). The side surface having a thickness of approximately 3 mm was irradiated with infrared laser to obtain a thermal diffusivity in an in-plane direction of the quartz glass on which the carbon film was formed. The infrared laser irradiation surface was subjected to blacking processing (the measurement and data analysis according to the laser flash method used in the example were carried out in accordance with a method described in "latest heat measurement - from base to application -" (supervised by Ichiro Hatta, edited by ULVAC-RIKO, Inc., AGNE GIJUTSU CENTER)) to increase infrared light absorption, and a rectangular parallelepiped sample obtained by superimposing only 30 sheets of quartz glass base materials without the carbon film was prepared, and the thermal diffusivity of the quartz glass base material alone was measured. From the measurement, the thermal diffusivity of the quartz glass base material with the carbon film and the thermal diffusivity of the quartz glass base material without the carbon film were compared to each other, and from the comparison, thermal diffusivity of the carbon film alone at 25°C in an in-plane direction was obtained. In addition, a specific heat and a density of the carbon film of the laminate were measured. By multiplying the thermal diffusivity by the specific heat and the density, a thermal conductivity of 30 W/mK or more was obtained with respect to the carbon film of the invention.

(Adhesiveness Test)

With regard to the laminate of the carbon film and the SUS440C base material, a test of adhesiveness of the carbon film with respect to the base material was carried out. The adhesiveness test was carried out by a scratch test. As a scratch tester, an ultra-thin film scratch tester CSR-2000 manufactured by Rhesca Corporation was used. In addition, a diamond probe having a tip radius of 25 $\mu$m, which is standardized for the device, was used as a probe. Measurement was carried out under measurement conditions of a scratch speed of 10 $\mu$m/s, a spring constant of 100 g/mm, an excitation level of 100 $\mu$m, a measurement termination load of 500 mN, and a measurement termination time of 180 s (an approximately load increase rate of 2.78 mN/s). In the measurement, as measurement and analysis computer software standardized for the device, CSR-2000 Data Analysis System Version 1.4.2 was used. From the measurement, even when a load to the maximum load (500 mN) was applied, the carbon film was not peeled off, and thus in the measurement, it could be seen that the peeling load was 500 mN or more.
In addition, a scratch test was carried out at a relatively higher load to correctly evaluate the adhesiveness of the carbon film laminate of the invention. At this time, the scratch test was carried out using a load variable friction and abrasion test system TiboGear HHS2000 manufactured by Shinto Scientific Co., Ltd, and a diamond stylus having a tip radius of 200 $\mu$m and a tip angle of 90°, which is standardized for the device. The measurement was carried out in a continuous load measurement mode under measurement conditions of a needle tip load of 0 to 1000 g, a measurement distance of 5 mm, and a measurement time of 50 seconds (a needle tip speed of 0.1 mm/sec). As a result of the test, the peeling load of the carbon film was 5.6 N.

(Friction and Abrasion Characteristic)

In the laminate of the carbon film and the base material of the invention, particularly, the laminate with the SUS440C stainless steel base material, evaluation of friction and abrasion characteristics was carried out. In a friction and abrasion characteristic test, a constant weighting reciprocating test having a ball on plate or pin on plate configuration was carried out using a load variable friction and abrasion test system TriboGear HHS2000 manufactured by Shinto Scientific Co., Ltd. The test was carried out at a normal temperature (a temperature of 22 to 27°C and humidity of 30 to 55%) in the air under a non-lubrication environment without using lubricating oil and the like. SUS440C stainless steel, which is the same material as the base material, was set as a friction counterpart material, and a ball having a diameter of 3/16 inches, or a pin in which a diameter is 5 mm and a radius of curvature of a tip portion (friction portion) is 30 mm was used. The test weighting was set to 1 N, a reciprocating amplitude was set to 10 mm, a reciprocating speed was set to 0.5 Hz, the total number of times reciprocating was 3600 times (total sliding distance was 72 m) or 9999 times (total sliding distance was approximately 200 m). In the measurement and analysis, as measurement and analysis computer software that is standardized for the device, tribosoftware ver.4.11 manufactured by Shinto Scientific Co., Ltd. was used.

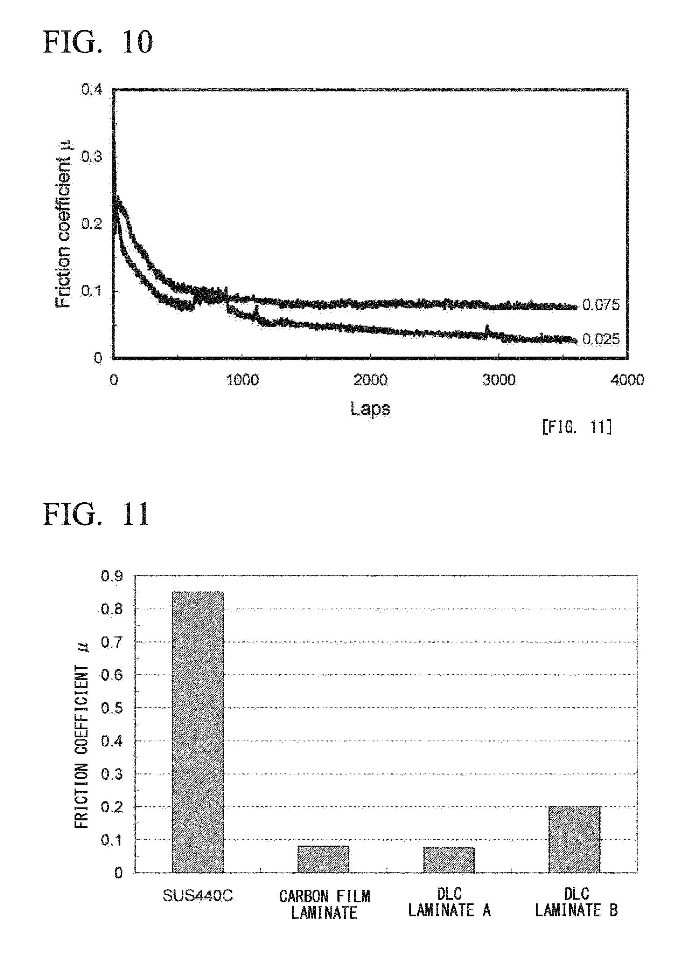

In FIG. 10, a variation of a friction coefficient with the passage of time during the test is shown. A test was carried out using a ball on plate, and the SUS440C (diameter of 3/16 inches) was used as a friction counterpart material. Immediately after initiating the test, the friction coefficient was large, as $\mu$ = 0.3 to 0.4. The friction coefficient became 0.1 or less after several hundreds of times reciprocating, the friction coefficient became substantially constant or gradually decreased, and became stable to 0.1 or less until the test was terminated. The same test was carried out multiple times with respect to the same laminate in which the thickness of the carbon film was 1.7 to 2 $\mu$m. From the test, it could be seen that the friction coefficient $\mu$ exhibited substantially the same variation, and ultimately (until 9999 reciprocating times) became 0.02 to 0.08. Among these, two typical examples are shown in FIG. 10.
For comparison with the carbon film laminate of the invention, the above-described friction and abrasion characteristic test was carried out with respect to an SUS440C base material on which the carbon film was not deposited, and samples (DLC laminate A and DLC laminate B) on which a commercially available DLC film were deposited on the same base material. In this case, the test was carried out in a pin on plate configuration, and the SUS440C pin (diameter of 5 mm, and a tip radius of 30 mm) was used as a counterpart material. The number of reciprocating times was set to 3500 times, and a load was set to 1 N. The DLC used for the DLC laminate A was tetrahedral amorphous carbon (ta-C) not containing hydrogen, and the DLC used for the DLC laminate B was hydrogen-containing amorphous carbon (a-C:H). Comparison of ultimately obtained friction coefficient between the carbon film laminate of the invention and these samples is shown in FIG. 11. As can be seen from the same drawing, the friction coefficient of the carbon film laminate of the invention dramatically decreases in relation to the laminate of SUS440C and SUS440C (friction coefficient is approximately 0.85). In addition, it can be seen that the carbon film laminate of the invention exhibits a function (decrease in the friction coefficient) substantially equal to or greater than that of the DLC film (DLC laminate A and DLC laminate B) that was practically used in a surface treatment for lubrication.

Next, abrasion characteristics of the laminate were evaluated. In the carbon film laminate of the invention, the DLC laminate A, and the DLC laminate B, friction was small to a certain degree at which measurement of an abrasion amount due to friction was difficult, and only the pin that was the counterpart material was abraded. This result represents that all of the carbon film laminate, the DLC laminate A, and the DLC laminate B have hardness larger than that of the SUS440C pin at a friction surface. The friction surface of the pin is a spherical surface having a radius R of 30 mm, and an abraded surface is a flat surface in which an edge shape is circle. A radius r of the circle was measured, and an abrasion amount (volume) V was obtained using the following expression by measuring the radius R of the circle.

[Mathematical Expression 1]

$$V = \frac{\pi}{3}\left\{2R^3 - \left(2R^2 + r^2\right)\sqrt{R^2 - r^2}\right\}$$

Generally, a wear rate is used to express the magnitude of abrasion damage. The wear rate represents an abrasion amount per unit load and unit friction distance. When the magnitude of the load is set as N, and the friction distance is set as L, the wear rate Ws is obtained by the following expression.

[Mathematical Expression 2]

$$W_s = \frac{V}{NL}$$

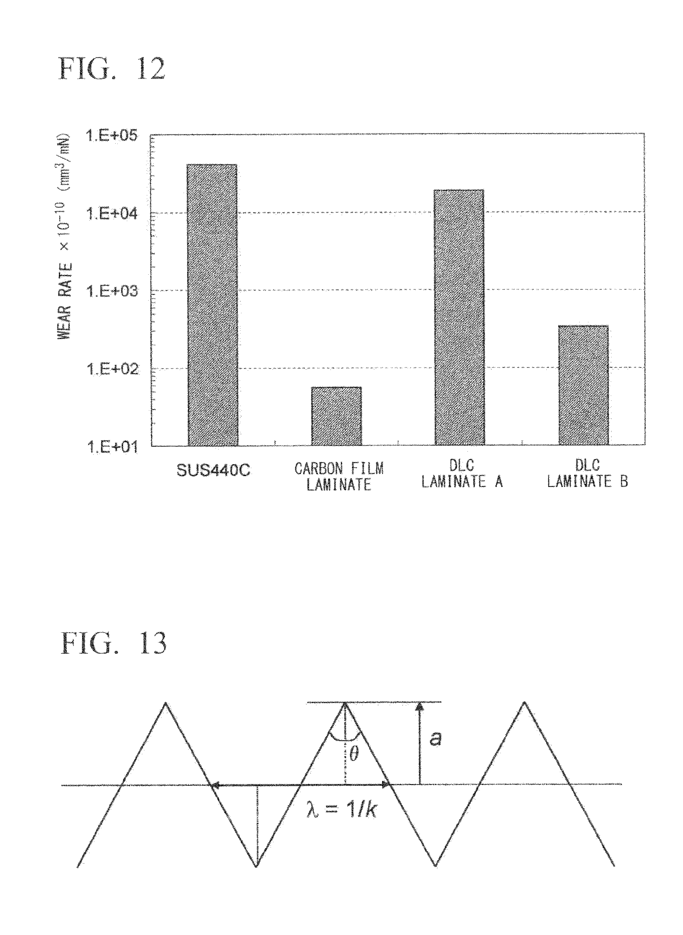

In the pin on plate friction and abrasion test, the wear rate of the SUS440C that was a friction counterpart material was obtained by the above-described method. In this case, the load N was 1 N, and the friction distance L was 0.02x3600 = 72 m. Results are shown in FIG. 12. As can be seen from FIG. 12, the wear rate of the counterpart material is significantly small in the carbon film laminate of the invention as described below. The wear rate of the counterpart material is smaller than that in the SUS440C base material not forming a laminate by three digits, is smaller than that in the DLC laminate A having the same friction coefficient as the carbon film laminate by two digits, and is smaller than that in the DLC laminate B by one digit. That is, it could be seen that when the carbon film of the invention was deposited on the SUS440C base material to form a laminate, the friction coefficient was largely decreased (to 0.1 or less) under a non-lubrication environment in the air, and at the same time, the counterpart aggressiveness was largely decreased.

When the above-described friction and abrasion test was carried out 9999 reciprocating times with respect to the carbon film laminate of the invention, the DLC laminate A, and the DLC laminate B, abrasion of the pin did not progress in most cases. Generally, with regard to friction between two kinds of materials, in many cases, abrasion progresses in the following manner. Abrasion dramatically progresses at an initial period of the friction (initial abrasion), and then abrasion does not progress so much (mild abrasion) (so-called "become familiar" phenomenon). Since the above-described case also corresponds to this manner, and abrasion transitions to the mild abrasion after 3600 reciprocating times, it is considered that abrasion did not progress in many cases. Accordingly, it could be seen that when forming the carbon film laminate of the invention, the initial abrasion was suppressed to be overwhelmingly smaller than, for example, the DLC laminate.

Generally, with regard to the friction of two kinds of materials, in a case where hardness of one material is larger than that of the other material, a soft material is one-sidedly abraded as long as a special reaction or adhesion does not occur on a friction surface. At this time, the soft material is abraded in such a manner that the soft material is ground off by unevenness on a surface of a hard material (abrasive wear). According to the abrasive wear theory, an abrasion volume is proportional to sharpness of a protrusion in the surface of the hard material, that is, when setting an average point angle of the protrusion to $\theta$, the abrasion volume is proportional to $\cot(\theta/2)$. Accordingly, as $\theta$ decreases (becomes sharp), the abrasion volume increases sharply. This represents that in a case of unevenness having a shorter spatial period (wavelength) with respect to the height, the abrasive wear becomes larger. Since the wavelength is a reciprocal number of the spatial frequency (wavenumber), as unevenness having a large wavenumber is less, the abrasive wear is suppressed. FIG. 13 shows a model of unevenness having a wavelength $\lambda$ (wavenumber k = $1/\lambda$), a height amplitude a, and a tip angle $\theta$. From FIG. 13, it can be seen that an abrasion volume $V_a$ due to the abrasive wear become as follows.

[Mathematical Expression 3]

$$V_a \propto \cot\frac{\theta}{2} = \frac{a}{\lambda/4} = 4ak$$

That is, the abrasion volume $V_a$ is proportional to a product of the amplitude a of the unevenness height and the wavenumber k.

Now, it is assumed that in the hard material, the power spectrum density P of a surface profile contour curve of a friction surface follows the power law, that is, $P \propto k^{-\alpha}$. At this time, when the amplitude of unevenness which corresponds to the wavenumber k is set as "a", since $P \propto a^2$, $a^2 \propto k^{-\alpha}$. Accordingly, $a \propto k^{-\alpha/2}$. From a relationship between this expression, the abrasion volume $V_a$, the amplitude a, and the wavenumber k, the following expression is obtained.

[Mathematical Expression 4]

$$V_a \propto ak \propto k^{1-\alpha/2} = k^{\frac{2-\alpha}{2}}$$

Accordingly, when $\alpha$ is larger than 2, the abrasive wear due to unevenness in which the wavenumber k is large (wavelength is short) decreases. On the contrary, when $\alpha$ is smaller than 2, abrasion due to unevenness in which k is large increases. As described above, in the power spectrum density of the surface profile contour curve of the carbon film laminate of the invention, which is shown in FIG. 8, it can be seen that in a range in which the wavenumber k is 0.5 to 10/$\mu$m, the power spectrum density follows the power law, and when $\alpha$ is as large as 4.7, an effect of high-wavenumber unevenness decreases sharply. According to this characteristic, very small counterpart aggressiveness of the carbon film laminate of the invention is realized.

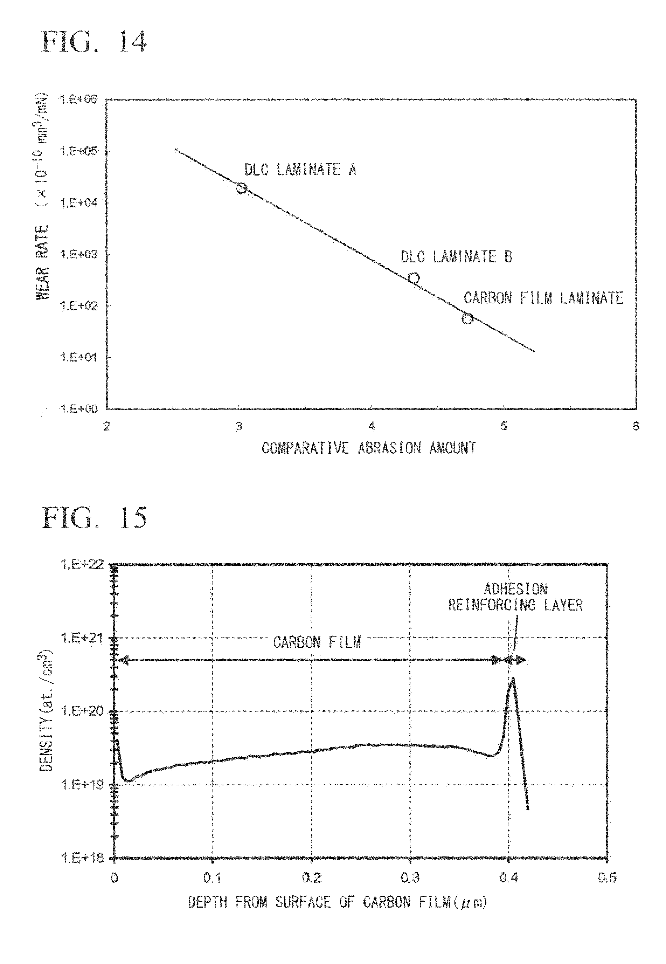

Similarly, surface profile contour curves in the DLC laminate A and the DLC laminate B were obtained according to the above-described method, and the power spectrums thereof were obtained. From the power spectrums, it was confirmed that the power spectrum density and the spatial frequency followed the power law, and the power law exponents were obtained. A graph that is obtained by plotting a relationship between the power law exponent and the wear rate is shown in FIG. 14. FIG. 14 is drawn with a semi-logarithmic graph, and in the semi-logarithmic graph, it can be seen that the wear rate and the power law exponent are in a linear relationship. This represents that the comparative abrasion amount and the power law exponent have an exponential function relationship and this is equal to the above-described results.

(Content of F)

Secondary ion mass spectrometry (SIMS) was carried out to measure a concentration of fluorine in the carbon film which has the above-described effect. As a primary ion, a cesium negative ion (Cs⁻) was used, and incident energy was set to 14.5 eV. The film thickness of a measured sample was approximately 0.4 $\mu$m. FIG. 15 shows a concentration distribution of fluorine atoms, which is obtained by measurement, from a surface of the carbon film to an interface with the base material. In this case, it can be seen that an atom density of fluorine atoms in the carbon film is in a range of $1 \times 10^{19}$ to $1 \times 10^{20}$ atoms/cm³, and the atom density exceeds $1 \times 10^{19}$ atoms/cm³ at the adhesion reinforcing layer portion. From examination with respect to a plurality of samples in which concentrations of fluorine atoms in the carbon film and the adhesion reinforcing layer are changed, it can be seen that when the fluorine atom density in the carbon film is $1 \times 10^{19}$ to $1 \times 10^{21}$ atoms/cm³, and the fluorine atom density in the adhesion reinforcing layer is $1 \times 10^{20}$ atoms/cm³ or more, the above-described effect is given in the most effective manner.

Industrial Applicability

The laminate of the carbon film and the iron-based base material of the invention has the above-described properties and is applicable to sliding members in which liquid or semi-liquid lubricant may not be used in the related art, for example, food processing machines, business machine components, aerospace machines, semiconductor-related manufacturing devices, special environments such as a vacuum environment, a clean environment, and an ultra-clean environment, ultra-small machines, and the like.

Reference Signs List

101: Plasma generation chamber

102: Rectangular waveguide tube with slot

103: Quartz member for introduction of microwave

104: Metallic support member that supports quartz member

105: Base material on which film is to be formed

106: Sample stage on which base material, on which a film is to be formed, is installed

107: Supply and drainage of cooling water

108: Exhaust

109: Plasma-generation-gas introducing unit

110: Reaction furnace

**Claims**

**1.** A carbon film laminate comprising:

a base material;
a carbon film adhesion reinforcing layer which is provided on the base material and which is formed from silicon oxide ($SiO_x$, x= 1 to 2) containing fluorine atoms (F) in a concentration of $1 \times 10^{19}$ atoms/cm³ or more; and
a carbon film that is formed on the carbon film adhesion reinforcing layer,
wherein the carbon film contains fluorine atoms in the film in a concentration of $1 \times 10^{19}$ to $1 \times 10^{21}$ atoms/cm³, and has an approximate spectrum curve obtained by superimposing, on a peak fitting curve A at a Bragg angle ($2\theta \pm 0.5°$) of 43.9° in an X-ray diffraction spectrum by $CuK\alpha_1$ rays, a peak fitting curve B at 41.7° and a baseline (here, the fitting curve A is expressed with a curve of a Pearson VII function, the fitting curve B is expressed with a curve of an asymmetric normal distribution function, and the baseline is expressed with a linear function).

2. The carbon film laminate according to claim 1,
wherein the surface roughness Ra of the carbon film is 20 nm or less.

3. The carbon film laminate according to claim 1 or 2,
wherein in a power spectrum of a surface roughness contour curve of the carbon film, a scaling exponent according to a power law is 3 to 5.

4. The carbon film laminate according to any one of claims 1 to 3,
wherein a friction coefficient of the carbon film at a temperature of 0°C to 50°C and humidity of 10 to 100% in the air is 0.01 to 0.1.

5. The carbon film laminate according to any one of claims 1 to 4,
wherein a light transmittance of the carbon film at a wavelength of 400 to 800 nm is 55% or more.

6. The carbon film laminate according to any one of claims 1 to 5,
wherein a light transmittance of the carbon film at a wavelength of 400 to 800 nm is 80% or more.

7. The carbon film laminate according to any one of claims 1 to 6,
wherein thermal conductivity of the carbon film is 10 W/mK or more, and resistivity at 100°C is $1 \times 10^7$ Ωcm (100°C) or more.

8. A method of manufacturing the carbon film laminate according to any one of claims 1 to 7, the method comprising:

   a process of treating a surface of a base material with ultrasonic waves;
   a process of allowing a nanocrystal diamond to adhere on the base material that is treated with ultrasonic waves; and
   a film forming process of carrying out a CVD treatment on the base material to which the nanocrystal diamond adheres to form a carbon film,
   wherein the film forming process is carried out by disposing the base material at a position at which an electron temperature of plasma becomes 0.5 to 3 eV by using a hydrogen gas, a hydrocarbon gas, an oxygen-containing gas, and a carbon fluoride-based gas.

9. A lubricant, comprising:

   the carbon film laminate according to any one of claims 1 to 7.

# FIG. 1

DIAMOND FINE PARTICLE THAT IS SEEDED

ADHESION REINFORCING LAYER

CARBON FILM

BASE MATERIAL

BASE MATERIAL

# FIG. 2

1. IN A CASE WHERE ADHESION REINFORCING LAYER IS NOT PRESENT OR IS VERY THIN

DIAMOND FINE PARTICLE THAT IS SEEDED

CARBON FILM

BASE MATERIAL

BASE MATERIAL

DIAMOND FINE PARTICLE THAT IS SEEDED

ADHESION REINFORCING LAYER

CARBON FILM

BASE MATERIAL

BASE MATERIAL

17

FIG. 3

| QUARTZ WINDOW | QUARTZ WINDOW |

ADHESION REINFORCING LAYER

| BASE MATERIAL |

IMMEDIATELY AFTER FILM FORMATION IS INITIATED(TEMPERATURE OF BASE MATERIAL IS LOW)

CARBON FILM

ADHESION REINFORCING LAYER

| BASE MATERIAL |

TIME HAS PASSED TO A CERTAIN DEGREE(TEMPERATURE OF BASE MATERIAL IS HIGH)

TEMPERATURE

THRESHOLD TEMPERATURE

RT

O

ADHESION REINFORCING LAYER

CARBON FILM

TIME

# FIG. 4

# FIG. 5

## FIG. 6

## FIG. 7

FIG. 8

FIG. 9

# FIG. 10

[FIG. 11]

# FIG. 11

## FIG. 12

## FIG. 13

FIG. 14

FIG. 15

**EP 2 708 617 A1**

## INTERNATIONAL SEARCH REPORT

| | International application No. |
|---|---|
| | PCT/JP2012/062061 |

| A. CLASSIFICATION OF SUBJECT MATTER |
|---|
| *C23C16/27*(2006.01)i, *C10M103/02*(2006.01)i, *C10N30/06*(2006.01)n, *C10N40/02* (2006.01)n |

According to International Patent Classification (IPC) or to both national classification and IPC

| B. FIELDS SEARCHED |
|---|
| Minimum documentation searched (classification system followed by classification symbols) |
| C23C16/27, C10M103/02, C10N30/06, C10N40/02 |

Documentation searched other than minimum documentation to the extent that such documents are included in the fields searched
Jitsuyo Shinan Koho          1922-1996     Jitsuyo Shinan Toroku Koho    1996-2012
Kokai Jitsuyo Shinan Koho    1971-2012     Toroku Jitsuyo Shinan Koho    1994-2012

Electronic data base consulted during the international search (name of data base and, where practicable, search terms used)

| C. DOCUMENTS CONSIDERED TO BE RELEVANT |
|---|

| Category* | Citation of document, with indication, where appropriate, of the relevant passages | Relevant to claim No. |
|---|---|---|
| A | WO 2007/004647 A1 (National Institute of Advanced Industrial Science and Technology), 11 January 2007 (11.01.2007), entire text & US 2009/0226718 A1    & EP 1911859 A1 | 1-9 |
| A | JP 2007-023331 A (National Institute of Advanced Industrial Science and Technology), 01 February 2007 (01.02.2007), entire text (Family: none) | 1-9 |
| A | JP 2005-330556 A (National Institute of Advanced Industrial Science and Technology), 02 December 2005 (02.12.2005), entire text (Family: none) | 1-9 |

| ☐ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 12 July, 2012 (12.07.12) | 24 July, 2012 (24.07.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H10095694 B
- WO 2005103326 A
- WO 20074647 W

**Non-patent literature cited in the description**

- *Surface and Coatings Technology,* 1993, vol. 57, 155-162
- *Diamond and Related Materials,* 1998, vol. 7, 1291-1302